# EUROPEAN PATENT SPECIFICATION

(11) **EP 1 383 844 B1**
(45) Date of publication and mention of the grant of the patent: **26.10.2005**
(21) Application number: 02728674.9
(22) Date of filing: 04.04.2002
(51) Int. Cl.: C09J 7/00, C09J 163/00, C09J 11/00

(54) **A THERMOSETTING ADHESIVE FILM, AND AN ADHESIVE STRUCTURE BASED ON THE USE THEREOF**
WÄRMEHÄRTENDER KLEBEFILM SOWIE AUF DESSEN VERWENDUNG BASIERENDE KLEBESTRUKTUR
FILM ADHESIF THERMODURCISSABLE ET STRUCTURE ADHESIVE BASEE SUR L'UTILISATION DE CELUI-CI

(30) Priority: 20.04.2001 JP 2001123318
(43) Date of publication of application: 28.01.2004
(73) Proprietor: 3M Innovative Properties Company, St. Paul, MN 55133-3427 (US)
(72) Inventor: KAWATE, Kohichiro, Machida-city, Tokyo 194-0041 (JP); ISHII, Shigeyoshi, Hachiouji-city, Tokyo 193-0934 (JP); HARA, Tomihiro, Sagamihara-city, Kanagawa 229-1132 (JP); YOSHIDA, Yuko, Sagamihara-city, Kanagawa 229-0021 (JP)
(74) Representative: Meyers, Hans-Wilhelm
(86) International application number: PCT/US2002/010644
(87) International publication number: WO 2002/086003

(56) References cited:
- EP-A- 1 085 790
- WO-A-99/50369
- CHEMICAL ABSTRACTS, vol. 114, no. 4, 28 January 1991 (1991-01-28) Columbus, Ohio, US; abstract no. 25457, TAKAGI, MASAMI ET AL: "Epoxy resin adhesives for printed circuit boards" XP002109297 & JP 02 001789 A (MATSUSHITA ELECTRIC WORKS, LTD., JAPAN;DAITO SANGYO K. K.) 8 January 1990 (1990-01-08)

## Description

### Field of the Invention

The present invention relates to a thermosetting adhesive film to be used, for example, as an interlayer insulation material of multilayer PCB (printed circuit board), and a structure using the film adhesive.

### Description of the Related Art

A printed circuit board is obtained by forming electric circuits (to be referred to as "conductor layers" or "wiring layers" hereinafter) with copper foils or through copper deposition on an insulative board, and thus comprise electronic parts such as semiconductor chips thereon, to enable the dense integration of electronic parts. A printed circuit board obtained as a multilayer PCB called a built-up board will be highly desirable if it can be incorporated in a small or thin portable electronic device where highly dense integration of electronic parts is required.

A multilayer PCB comprises two or more metallic conductor layers with an insulating layer inserted between adjacent conductor layers. Generally, the insulating layer is made from an organic material. The typical organic material includes thermosetting resins such as epoxy resins, and generally has a higher CTE (coefficient of thermal expansion) than the inorganic materials such as semiconductors and metals. As a consequence, a thermal stress may develop between a conductor layer and an insulating layer in contact with the conductor layer as a result of temperature changes. In the worst cases, such a thermal stress may become so large as to cause the conductor and insulating layers to be deformed (curved or bent), thereby impairing the electric connection (such as via connection) of wiring layers, causing the failed connection of circuits, or interlayer delamination.

If an organic material to which inorganic particles have been added as a filler is used, the resulting organic material may come to have a CTE closer to that of the inorganic materials, that is, the CTE of the organic material may lower sufficiently to be close to that of the inorganic materials. In addition, it may thereby come to have a higher elastic modulus, thereby effectively avoiding the occurrence of the above deformations. However, for an organic material, for example, an epoxy resin to be provided with a sufficiently low CTE and a sufficiently high elastic modulus, it will require, in certain cases, the addition of a comparatively large amount of filler, for example, 25 vol.% or more of filler with respect to the volume of solid resin may be required (see, for example, H. M. Mcilroy: "Linear Thermal Expansion of Filled Epoxy Resin," 30th Anniversary Technical Conference, Section 4-A, 1975). If a large amount of filler is added, the insulating layer may not be able to develop the desired adhesive force because the relative content of thermosetting resin(s) in the insulating layer is reduced. Moreover, the toughness of such an insulating layer tends to decline, because a large number of filler particles readily come into contact with each other, to form networks (Haraguchi, K., "Functional Materials," 1999, Vol. 19, No. 10, p. 42). In addition, it is difficult to handle an uncured green sheet.

Such an organic material to which a relatively high amount of filler is added as described above may be effectively used as an underfill material to reinforce soldered junctions between a board and a semiconductor chip as disclosed, for example, in Japanese Patent Publication (Kokai) No. 10-158366. However, an organic material to which more than 25% by volume of filler is added has not typically been used as an insulator (for example, material for insulating the interfaces) of a multilayer PCB. Currently, the insulating layer is made of a prepreg which is obtained by impregnating a thermosetting resin in a reinforcing material such as glass cloth. However, it is often difficult to process the reinforcing material such as glass cloth into a thin film, and hence an insulating layer made from such a material may not be made sufficiently thin. In addition, the insulating layer is hardly subject to fme processing based on a laser beam.

In view of above, the present invention provides a thermosetting adhesive film and an adhesive structure, which maintain a desired CTE and elastic modulus, without reduction of an adhesive force caused by the addition of a large amount of filler material.

### Summary of the Invention

This invention provides, as one embodiment, a thermosetting adhesive film comprising:
a uniform adhesive matrix containing a thermosetting resin, a curing agent therefor, and a thermoplastic agent; and
a filler material dispersed in the adhesive matrix, wherein the filler material comprises:
   an inorganic material; and
   a domain to incorporate the inorganic material,
   the domain consisting of an elastic polymer which is elongated and oriented in one direction substantially perpendicular to the thickness direction of the adhesive film.

The adhesive film configured as above will give a cured product having a high elastic modulus and low CTE even when a comparatively small amount of filler material is added thereto. In addition, because the film permits the filler material to be added at a low level, the adhesive film, even when uncured, exhibits a high strength and is easily subject to processing, and the cure product exhibits toughness and strong adhesive force.

The adhesive film configured as above is obtained, in one embodiment of this invention, by coating, in one direction with a shear force, a coating composition comprising a uniform adhesive matrix-forming component comprising a thermosetting resin and its curing agent, and a thermoplastic resin which are miscible with each other, and a filler material dispersed in the adhesive matrix-forming component.

The term "miscible to each other" as used herein, means that the involved components are miscible to each other to the extent that they will not phase-separate from each other, when the coating composition therefrom is coated to give an adhesive film, and thus will allow the composition to form a uniform film.

### Brief Description of the Drawings

Fig. 1 shows a cross-section of one embodiment of an adhesive structure which uses an adhesive film of this invention as an interlayer insulating material.
Fig. 2 shows a photograph taken by transmission electronmicroscopy (TEM), of the texture of the cross-section of a cured product obtained from the adhesive film of this invention.

### Reference Numerals

1 - Adhesive structure
2 - Cured product of an adhesive film
3, 3' - Wiring layer

### Detailed Description of the Invention

An adhesive film of this invention is formed from a thermosetting resin which will not exhibit reduced adhesive forces as is typical in adhesives to which a large amount of filler is added, and will give a desired CTE and elastic modulus. Such an adhesive film is useful as a material of an insulating layer for a multilayer PCB, particularly as an interlayer insulating material.

The adhesive film of this invention usually comprises an adhesive matrix and a filler material dispersed in the matrix, as will be detailed below. The adhesive matrix comprises a thermoplastic resin, and itself takes a definable form such as a film. The typical thermoplastic resin may include, for example, polyethylene terephthalate, polycarbonate, polyether sulfone, polyether imide, polyacrylate, polymethyl methacrylate, polystyrene, polyvinyl acetate, polycaprolactone, phenoxy resins, and various polyesters. Phenoxy resins are particularly preferred because they are highly miscible to epoxy resins. If a phenoxy resin molecule has at least one ethylenic bond having a radical reactivity, the ethylenic bond will provide a cross-linking point of phenoxy resin molecules, and will produce a cross-linked structure in the presence of a polymerization initiator where phenoxy resin molecules are united together through the cross-linking of the ethylene bond. Such a cross-linking structure will permit the adhesive film to have an increased elastic modulus. The thermoplastic resin has a number-average molecular weight of from about 1,000 to about 1,000,000. If a thermoplastic resin has a number-average molecular weight less than about 1,000, the green sheet therefrom (adhesive film before cure) tends to have a reduced cohesive force. On the contrary, if a thermoplastic resin has a number-average molecular weight more than about 1,000,000, the coating composition therefrom will have such a high viscosity that its coating process will be difficult. The preferred number-average molecular weight is in the range of from 5,000 to 500,000.

According to this invention, the adhesive matrix is thermosetting, and will provide, once cured, an adhesive film with a high adhesive force, water-resistance, solvent resistance and weather resistance. Usually such a thermosetting adhesive matrix further comprises a thermosetting resin and a curing agent therefore. The typical thermosetting resin includes various epoxy resins. Particularly, bis-phenol A type epoxy resins are preferred because they are readily miscible to phenoxy resins. If the thermosetting resin is an epoxy resin, the epoxy resin has an epoxy equivalent of from 100 to 5,000. An epoxy resin having an epoxy equivalent below about 100 is not readily available. On the contrary, if the epoxy resin has an epoxy equivalent over about 5,000, the density of cross-linking will decline, and the thermal resistance of the adhesive film tends to become low. The particularly preferred epoxy equivalent is from 170 to 500.

The curing agent is not limited to any specific agent, provided that it can cause the thermosetting resin to cure. However, preferred agents include an amine (dicyandiamide), carboxylic acids, anhydrous acids, thiol compounds and imidazole compounds. The curing agent is preferably not dissolved in the matrix when the adhesive film is dried because the curing reaction does not tend to occur when stored at a room temperature, if the curing agent is not miscible.

The thermosetting resin and the thermoplastic resin described above may be blended at any desired blending ratio, provided that they are miscible to each other in the coating composition. However, from the view-point of making the uncured adhesive film (green film) easy for handling and providing it with thermal resistance, thermosetting resin and the thermoplastic resin are preferably blended at a ratio of from 70/30 to 5/95, more preferably from 60/40 to 10/90 on a weight basis.

The coating composition usually contains a solvent. From the view-point of making the adhesive film easy for drying, the solvent is preferably a solvent having a comparatively low boiling point such as acetone, ethyl acetate, methylethyl ketone (MEK), or methanol (MeOH). A mixture of MEK and MeOH is preferred.

The adhesive film of this invention contains a filler material substantially uniformly dispersed in the adhesive matrix. The filler material is generally separated from the adhesive matrix. A preferred filler material contains an inorganic substance and a domain to incorporate the inorganic substance. The inorganic substance is used to provide the adhesive film with a high elastic modulus and a low CTE, and the shape of its primary particles is not critical. Generally, the inorganic substance includes, for example, silica (SiO₂), antimony pentoxide, alumina, talc, titanium oxide, silicon nitride, metal (copper, silver, aluminum, gold, etc.), carbon powders etc. Particularly, if the inorganic substance consists of an organic sol of silica, dispersion of the inorganic substance will be effectively achieved. This is because such an inorganic substance has the ability to selectively invade into rubber particles. The inorganic filler substance preferably has an average diameter of 0.00001 to 10 µm. If the inorganic substance had an average diameter less than about 0.00001 µm, its contribution to an increased elastic modulus would become somewhat low. Or, if the inorganic substance had an average diameter more than about 10 µm, application of the coating composition would become somewhat difficult.

The above-described inorganic substance is incorporated and exists in the domain or on the surface of the domain. The domain is elongated and oriented to one direction substantially perpendicular to the thickness direction of the adhesive film. As a consequence, even if the amount of inorganic substance added to the adhesive film is reduced, the adhesive film will be effectively provided with a high elastic modulus and a low CTE in its oriented direction. Particularly, if the domain is in the form of slender fibers, the inorganic substance will effectively provide the adhesive film with a high elastic modulus and a low CTE at a lower concentration. Due to reduction of the addition amount of the inorganic substance, the resulting adhesive film will give, once cured, a cured product having toughness and high adhesive force. Furthermore, the uncured adhesive film will be strong enough that the handling of the green sheet will be easy.

The preferred domain consists of an elastic body (elastic polymer) such as a thermoplastic resin or a rubber-like polymer, and is easily deformed. This is due to the fact that such a domain can be easily oriented to a specified direction and modified to take a fibrous shape, when the adhesive film is produced as described below. The thermoplastic resin may include polyvinyl alcohol, polyvinyl acetate and silicone resins or a homopolymer of an acrylate, a methacrylate, an acrylic amide or an acrylonitrile or a copolymer of two or more of these monomers, and the rubber-like polymer may include polybutadiene, polyisoprene, acrylic rubber, butadiene-acrylonitrile rubber and a carboxylic terminated butadiene-acrylonitrile rubber.

Typically, the domain oriented as described above has a length of from 0.1 to 1000 µm and a width of from 0.1 to 10 µm. The domain is preferably incorporated at from 2 wt% to 100 wt.% of the adhesive matrix, so that it can provide the adhesive film with sufficient heat resistance. Preferred domains contain from 2wt% to 90 wt.% of inorganic substance.

The above-described adhesive films are particularly useful as an insulating layer of a multilayer PCT, or an interlayer insulating material if they are laminated to give a film where the domains in alternate layers, e.g., are oriented at right angles to each other. This is because such a laminated film cancels out the anisotropy of each adhesive film layer while retaining the high elastic modulus and the low linear CTE of each adhesive film layer. By use of this laminating method, it is possible to reduce thermal stresses which might otherwise occur as a result of temperature changes between an insulating layer and adjacent conductor layers (first and second adherend), and thus prevent the insulating and conductor layers from being deformed (curved or bent). This prevents failure of electric connections such as via connection between wiring layers, interruption of wiring of an electric, and interface delamination.

For a multilayer PCB having a high aspect ratio (first adherend), or for a semiconductor IC chip having an anisotropic electric circuit (second adherend), the adhesive film of this invention may be used singly as an underfill. For example, for a multilayer PCB having a high aspect ratio, a thermal stress developing in lengthwise direction is comparatively large. Therefore, the adhesive film may be applied to allow its domain to have an orientation with respect to the lengthwise direction of the multilayer PCB so as to minimize the thermal stresses which would otherwise develop in the PCB.

The adhesive film of this invention may be produced by any known and conventional method, but is preferably made by the following method.

First, solution containing a thermoplastic resin, and a thermosetting resin and its curing agent as described above and an optional solvent is prepared and mixed. Next, the mixed solution is stirred at a specific temperature, for example, at room temperature (25°C) for a specific time, and then a filler material is added to the solution, to give a coating composition. Usually, the resulting coating composition should have a viscosity of 1 Pascal seconds (Pa.s) (1000 cps) to 1000 Pa.s (1,000,000 cps). This is because, if the composition had a viscosity less than 1 Pa.s, a sufficiently high shear could not be applied to the composition during coating, and thus the domain would not be oriented. The composition having a viscosity of 2000 cps or higher is preferred because it will allow the domain to be effectively oriented. On the contrary, if the coating composition has a viscosity over 1000 Pa.s, its easiness of application would be so impaired that it would be difficult to prepare the composition into a film.

Next, the coating composition is applied, for example, onto substrate film consisting of a polyethylene terephthalate (PET) in one direction with a shearing force. According to this invention, the coating composition is preferably applied at a shearing rate of 100 (1/sec) or more. This is because the domain incorporating a filler material easily exceeds the elasticity limit to be effectively oriented to one direction along which a shearing force is applied to the composition, substantially independently of the thickness of the coat. Particularly, the shearing rate is preferably set at 200 (1/sec), because then the orientation will be high. On the contrary, if the shearing rate is set above 1,000,000 (l/sec), coating rate is so high that it is difficult to dry the resulting film in an oven.

The coating method is not limited to any specific one, provided that it can permit the coating composition to be applied at a shearing rate as described above. The exemplary coating method may include die-coating, knife-coating, and coating based on a rotary rod die. However, the coating method based on die-coating is preferred because it can permit the coating composition to be applied with a high shearing force. Later, the coating composition is optionally heated together with the substrate film at a specific temperature, to remove the solvent and to give an adhesive film. Further, two or more such film adhesives may be bonded together with a heating roller to give a laminated film as described above.

The adhesive film of this invention is used as an adhesive structure obtained by laminating an adhesive film and appropriate adherend. For example, a cured product of an adhesive film of this invention, a first adherend applied to one surface of the cured product of an adhesive film and a second adherend applied to the other surface of the same film adhesive are bonded together to give a lamination.

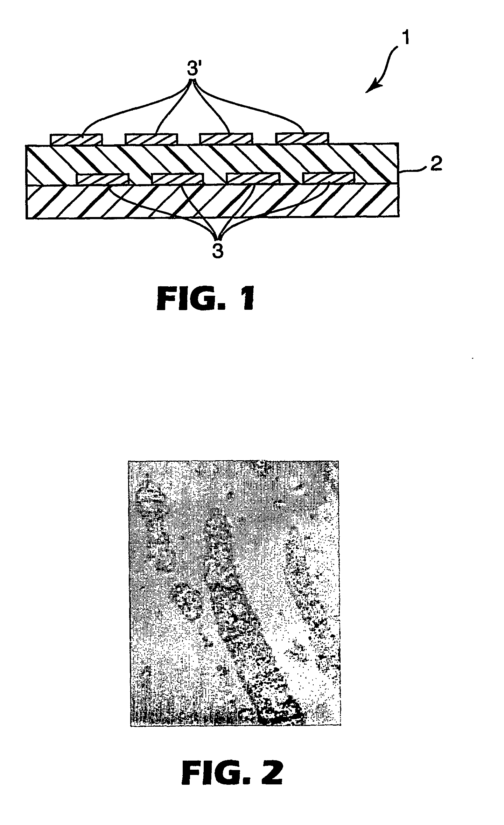

Fig. 1 shows a cross-section of an adhesive structure representing an embodiment which uses an adhesive film of this invention as an interlayer insulating material. The adhesive structure 1 comprises a cured product of an adhesive film 2, and wiring layers 3 and 3' (first and second adherends respectively) applied respectively to the upper and lower surfaces of the cured product of an adhesive film 2. Such an adhesive structure may be produced as follows. An adhesive film is applied onto a substrate (not illustrated) using an appropriate method such as heat laminating; a layer composed of conductors made from copper foils is formed thereupon; and the adhesive film is subject to thermal curing. Next, a desired wiring pattern is etched to give a wiring layer 3 (first adherend). An adhesive film is applied thereupon, and the same procedure as described above is repeated so that cured product of an adhesive film 2 and wiring layer 3' (second adherend) can be formed.

Further, as described above, an adhesive structure may be obtained wherein the first adherend is a multilayer PCB, and the second adherend is a semiconductor IC chip, and the adhesive film of this invention is used as an underfill for these adherend.

According to this invention, the cured product of an adhesive film will have an elastic modulus of from 1 to 1000 MPa in the oriented direction of the domain, and of 0.1 - 10 MPa in a direction normal to the oriented direction when measured at 150°C. Further, the cured product of an adhesive film, will have a CTE of 1 - 200 x 10⁻⁶ /°C in the oriented direction of the domain, and of 10 - 500 x 10⁻⁶ /°C in a direction normal to the oriented direction when measured at -50 to 150°C. The film having properties as described above, when used as an insulating layer, will not develop a large thermal stress between the conductor layer and the insulating layer due to a temperature change. Accordingly, the conductor layer and the insulating layer thereupon will not be subject to deformations; electric connections between wires will be stable; and interruptions of electric circuits and interlayer delamination will be effectively avoided, which are preferable effect.

### Examples

The present invention will be described by means of the following Examples. However, the scope of the invention is not limited to these examples.

Firstly, two kinds of solutions having compositions, solids, and viscosities as described in Table 1 were prepared and mixed. Next, the mixed solution was stirred at room temperature (25°C) for about eight hours, and an inorganic substance was added to be adsorbed to the phases mainly composed of rubber-like particles of an acrylic resin, to give a coating composition.

### Ingredients

- YP50S:: phenoxy resin (number averaged molecular weight, 11,800) manufactured by Tohto Kasei Co., Ltd.
- DER332:: epoxy resin (epoxy equivalent, 174) manufactured by Dow Chemical Japan.
- RD102:: acrylic polymer dispersed in epoxy resin (content of acryl, 40 wt.%) manufactured by NOF Corporation.
- MEK-ST:: SiO₂ sol in MEK (content of SiO₂, 30 wt.%) manufactured by Nissan Chemical Industry, Co., Ltd.
- DICY:: dicyandiamide
- TDI-urea:: toluene bisdimethyl urea manufactured by ACI Japan Ltd, Omicure™ 24
- MeOH:: methyl alcohol
- MEK:: methyl ethyl ketone

**Table 1**

| | Mixed Solution 1 | Mixed Solution 2 |
|---|---|---|
| YP50S | 55 | 55 |
| DER332 | 25 | 25 |
| RD 102 | 20 | 20 |
| MEK-ST | 50 | 50 |
| DICY | 2.9 | 2.9 |
| TDI-Urea | 0.5 | 0.5 |
| MeOH | 40 | 40 |
| MEK | 50 | 110 |
| Solid % | 48.6 | 39.0 |
| Viscosity (cps) | 4000 | 500 |

Each coating composition as described above was then applied by die-coating onto a substrate PET film having a thickness of 50 µm. The coating composition was fed with a gear pump via a filter (HC25XB, ROKI Technology Co., Ltd.) to a die to be extruded at a rate of from 180 to 200 ml/min, and coated onto the substrate film under the condition as described in Table 2. Then, the coating composition applied to the substrate film was placed in an oven. The coating composition was heated/dried at from 100 to 130°C in the oven to remove the solvents of MEK and MeOH to produce an adhesive film.

**Table 2**

| | Mixed Solution | Coating speed (m/min) | Shear rate (1/sec) | Film thickness (µm) |
|---|---|---|---|---|
| Example 1 | Mixed Solution 1 | 5 | 810 | 25 |
| Example 2 | Mixed Solution 1 | 2 | 160 | 50 |
| Example 3 | Mixed Solution 2 | 5 | 650 | 25 |

Next, the adhesive film of each example were evaluated with respect to the following items.

### 1. Determination of the dynamic Young's modulus

Each of the test adhesive films was heated at 150°C for two hours to a cured product. Later the cured product was tested for its dynamic Young's modulus with a dynamic analyzer (RSA, Rheometrics Co.). The storage Young's modulus or dynamic Young's modulus (E' at ω of 6.28 rad/sec) was measured when the temperature was raised from 30°C to 260°C at 5°C/min. Table 3 lists the dynamic Young's moduli E' determined at 150°C in a direction parallel to the coating direction (shearing direction, MD direction) and a direction normal to the coating direction (TD direction). According to the results of Table 3, it is obvious that the test sample exhibits a high elastic modulus of 100 MPa or more when measured in a direction parallel to MD direction or the oriented direction. This test demonstrates that the adhesive film of this invention, although it incorporates the inorganic substance at an amount which would normally permit the film to have a low elastic modulus of approximately 20 MPa, can exhibit an elastic modulus as high as 50 MPa or more.

The test adhesive film of Table 3 was a lamination composed of two adhesive films of Example 1 in which the lamination was made with a heating roller at 120°C such that the oriented directions (shearing directions) were at right angles to each other.

**Table 3**

| | Modulus parallel to TD direction (MPa) | Modulus parallel to MD direction (MPa) |
|---|---|---|
| Example 1 | 17 | 120 |
| Example 2 | 22 | 140 |
| Example 1 (TD+MD)¹⁾ | 60 | 60 |
| Example 3 | 18 | 22 |

The following table (Table 4) shows the temperature dependence of the dynamic Young's moduli E' of the adhesive film of Example 2. As can be seen from the results, the material of the adhesive film shows an anisotropic property at high temperature. Generally, a laminated article such as PCB develops an anisotropic stress at high temperature, as in the process of soldering. Such heat stress can be lowered by laminating adhesive films of the present invention in the direction which reduces the anisotropy.

**Table 4**

| Temperature (°C) | Modulus parallel to TD direction (MPa) | Modulus parallel to MD direction (MPa) |
|---|---|---|
| 27 | 2000 | 2000 |
| 47 | 2000 | 2000 |
| 68 | 1800 | 1900 |
| 88 | 1700 | 1800 |
| 108 | 430 | 590 |
| 128 | 47 | 190 |
| 148 | 22 | 140 |
| 168 | 15 | 94 |
| 188 | 14 | 72 |

### 2. Determination of coefficient of linear thermal expansion (linear CTE)

The linear CTE of the adhesive film of Example 2 was also determined as follows.

Firstly, the test adhesive film was heated at 150°C for two hours to produce a cured product. Then, the linear CTEs of the cured product were determined at 20°C and 140°C with a device (Thermoplus, Rigaku Electric Co.). Table 5 shows linear CTEs determined at 20°C and 140°C in a direction parallel to the coating direction (shearing direction, MD direction) or in a direction normal to the coating direction (TD direction). Table 5, which follows, shows that when measured at 140°C, the test sample shows a low CTE in an MD direction. It was demonstrated from this test that the adhesive film of this invention, although it incorporates the inorganic substance at an amount which would, if given to a conventional adhesive film, cause it to have a CTE as high as 400 x 10⁻⁶ m/°C or higher, can exhibit a CTE as low as 200 x 10⁻⁶ m/°C or lower.

**Table 5**

| Temperature (°C) | Coefficient of linear thermal expansion parallel to TD direction (× 10⁻⁶m/°C) | Coefficient of linear thermal expansion parallel to MD direction (× 10⁻⁶m/°C) |
|---|---|---|
| 20 | 81 | 72 |
| 140 | 420 | 150 |

### 3. Determination of adhesive force

The adhesive force of the adhesive films of Examples 1 and 2 were determined as follows.

An adhesive film was laminated onto a polyimide film (Kapton™ V, Dupont) with a thickness of 25 µm by heating (120°C, 2 Kg, rate at 2 m/min). The resulting adhesive film was further laminated with a roll copper foil with a thickness of 35 µm to give a laminate. Later, the laminate, while being heated at 120°C, press-bonded at a pressure of 20 kg/cm2 for 60 sec. Then, the laminate was heated at 150°C for two hours, to cure and to give a test adhesive film. Then, using this test film, a 180 degree peel strength was measured with respect to the rolled copper foil and to the polyimide film, to determine thereby the adhesive strength of the cured adhesive film. During the test, the peeling direction was maintained in a direction parallel to the coating direction of adhesive film (shearing direction, MD direction), or in a direction normal to the coating direction (TD direction).

Table 6 shows the linear CTEs of the test film measured at 20°C and 140°C in a direction parallel to the coating direction (shearing direction, MD direction) and in a direction normal to the coating direction (TD direction). The results of Table 6 show that the adhesive force of the test film does not significantly vary whether measured in an MD direction or in a TD direction. This demonstrates that the adhesive film of this invention is anisotropic in its elastic modulus etc., but isotropic in its adhesive force.

**Table 6**

| Specimen | Adhesive strength parallel to TD direction (N/cm) | Adhesive strength parallel to MD direction (N/cm) |
|---|---|---|
| Example 1 | 9.4 | 9.0 |
| Example 2 | 10.3 | 9.8 |

### 4. Measurement of the tensile strength of uncured resin

The adhesive film of Example 2, while being uncured, was stretched and its breaking strength and elongation were determined. This stretching test was performed with a tensile strength tester (Tensilon™) manufactured by Toyo Baldwin Co. The stretching rate was kept at 50 mm/min. Table 7 shows the breaking strength and elongation of the test adhesive film measured at 25°C in a direction parallel to the coating direction (shearing direction, MD direction) and in a direction normal to the coating direction (TD direction). The results of Table 7 show that the test film has a high breaking strength, even when it is uncured. Particularly, it has a higher breaking strength in an MD direction. This demonstrates that the adhesive film of this invention is extremely strong, even when it is kept uncured, and thus permits easy handling.

**Table 7**

| | TD direction | MD direction |
|---|---|---|
| Breaking strength (N/cm²) | 1900 | 3100 |
| Elongation (%) | 2 | 4 |

### 5. Morphology observation

The adhesive film of Example 1 was further heated at 150°C for two hours, to be cured. The cured product was sliced with a microtome, and the morphology of the cross-section of cured product was observed. Fig. 2 is a photograph of the cross-section of the cured product taken with a transmission-type electron microscope (TEM) (scale is indicated in the figure). The figure shows that acrylic phases contains inorganic particles oriented in the shearing direction, and that the acrylic phase is shaped like a rod with a length of from 5 to 100 µm, and width of about from 1 to 5 µm.

### Advantages

The adhesive film of this invention, even when incorporating a comparatively small amount of a filler material as an additive, gives a cured product having a high elastic modulus and a low CTE. Further, as the addition amount of a filler material can be lowered an uncured adhesive film has a high strength, is easily subject to processing, and its cured product is tough and has a high adhesive force.

## Claims

1. A thermosetting adhesive film having a first and a second major surface comprising:
a uniform adhesive matrix containing a thermosetting resin, a curing agent therefor, and a thermoplastic resin; and
a filler material dispersed in the adhesive matrix comprising:
an inorganic material; and
a domain incorporating the inorganic material,
the domain consisting of an elastic polymer which is elongated and is oriented in one orientation direction, substantially perpendicular to a thickness direction of the adhesive film.

2. An adhesive film, as described in claim 1 which is obtained by coating in one direction, with a shear force, a coating composition comprising a uniform adhesive matrix-forming component including a thermosetting resin and a curing agent therefor, and a thermoplastic resin, wherein the matrix-forming component and the resin are miscible with each other; and further comprising an inorganic filler material dispersed in the adhesive matrix-forming component.

3. An adhesive film, as described in claim 1 or 2, wherein the thermosetting resin is an epoxy resin and the thermoplastic resin is a phenoxy resin.

4. An adhesive film, as described in any one of claims 1 to 3, wherein the blend ratio of the thermosetting resin to the thermoplastic resin is from 70/30 to 5/95 on the basis of weight.

5. An adhesive film, as described in any one of claims 1 to 4, wherein the inorganic filler material is contained in the adhesive matrix-forming component at from 5 to 100 mass parts with respect to 100 mass parts of the adhesive matrix-forming component.

6. An adhesive film, as described in any one of claims 1 - 5, having an elastic modulus of from 1MPA to 1000 MPa in a direction parallel to the orientation direction of the domain, and an elastic modulus of from 0.1 MPa to 10 MPa in a direction normal to the orientation direction, when measured at 150°C after curing.

7. An adhesive film, as described in any one of claims 1 - 6, which has a coefficient of linear thermal expansion of 1 - 200 x 10⁻⁶/°C in a direction parallel to the orientation direction of the domain, and a coefficient of linear thermal expansion of 10 - 500 x 10⁻⁶/°C in a direction normal to the orientation direction, when measured at -50 to 150°C after curing.

8. A thermosetting adhesive film obtained by laminating a plurality of adhesive films, as described in any one of claims 1 - 7, into a multilayer lamination wherein adjacent layers have domains oriented at right angles to each other, and each of the laminated adhesive films is obtained by coating a coating composition having a viscosity of 1 - 1,000 Pa.s (1,000 - 1,000,000 cps) at a shear rate of 100 - 1,000,000 sec⁻¹.

9. An adhesive structure comprising:
a cured product obtained from an adhesive film, as described in any one of claims 1 - 8;
a first adherend attached to the first major surface of the cured product of the adhesive film; and
a second adherend attached to the second major surface of the cured product of the adhesive film.

## Patentansprüche

1. Hitzehärtbarer Klebefilm mit einer ersten und einer zweiten Hauptfläche, umfassend:
eine einheitliche Klebematrix, die ein hitzehärtbares Harz, ein Härtungsmittel dafür und ein thermoplastisches Harz enthält; und
ein in der Klebematrix dispergiertes Füllstoffmaterial, umfassend:
ein anorganisches Material und
eine das anorganische Material inkorporierende Domäne,
wobei die Domäne aus einem elastischen Polymer, das langgestreckt und in einer zu einer Dickenrichtung des Klebefilms weitgehend senkrechten Orientierungsrichtung orientiert ist, besteht.

2. Klebefilm nach Anspruch 1, der durch Auftragen einer Beschichtungszusammensetzung, die eine einheitliche klebematrixbildende Komponente mit einem hitzehärtbaren Harz und einem Härtungsmittel dafür und ein thermoplastisches Harz umfasst, wobei die matrixbildende Komponente und das Harz miteinander mischbar sind; und ferner ein in der klebematrixbildenden Komponente dispergiertes anorganisches Füllstoffmaterial umfasst, in einer Richtung mit einer Scherkraft erhalten wird.

3. Klebefilm nach Anspruch 1 oder 2, wobei es sich bei dem hitzehärtbaren Harz um ein Epoxidharz und bei dem thermoplastischen Harz um ein Phenoxyharz handelt.

4. Klebefilm nach einem der Ansprüche 1 bis 3, wobei das Mischungsverhältnis von hitzehärtbarem Harz zu thermoplastischem Harz 70/30 bis 5/95, bezogen auf das Gewicht, beträgt.

5. Klebefilm nach einem der Ansprüche 1 bis 4, wobei das anorganische Füllstoffmaterial in der klebematrixbildenden Komponente in einer Menge von 5 bis 100 Massenteilen, bezogen auf 100 Massenteile der klebematrixbildenden Komponente, enthalten ist.

6. Klebefilm nach einem der Ansprüche 1-5 mit einem Elastizitätsmodul von 1 MPa bis 1000 MPa in einer zur Orientierungsrichtung der Domäne parallelen Richtung und einem Elastizitätsmodul von 0,1 MPa bis 10 MPa in einer zur Orientierungsrichtung senkrechten Richtung bei Messung bei 150°C nach der Härtung.

7. Klebefilm nach einem der Ansprüche 1-6 mit einem linearen thermischen Ausdehnungskoeffizienten von 1-200 x 10⁻⁶/°C in einer zur Orientierungsrichtung der Domäne parallelen Richtung und einem linearen thermischen Ausdehnungskoeffizienten von 10-500 x 10⁻⁶/°C in einer zur Orientierungsrichtung senkrechten Richtung bei Messung bei -50 bis 150°C nach der Härtung.

8. Hitzehärtbarer Klebefilm, der durch Lamininieren mehrerer Klebefilme nach einem der Ansprüche 1-7 zu einem Mehrschichtlaminat erhalten wird, wobei benachbarte Schichten rechtwinklig zueinander orientierte Domänen aufweisen und jeder der laminierten Klebefilme durch Auftragen einer Beschichtungszusammensetzung mit einer Viskosität von 1-1000 Pa.s (1000-1.000.000 cP) bei einer Scherrate von 100-1.000.000 s⁻¹ erhalten wird.

9. Klebestruktur, umfassend:
ein aus einem Klebefilm nach einem der Ansprüche 1-8 erhaltenes gehärtetes Produkt;
ein erstes Klebeteil, das an die erste Hauptfläche des gehärteten Produkts des Klebefilms gebunden ist; und
ein zweites Klebeteil, das an die zweite Hauptfläche des gehärteten Produkts des Klebefilms gebunden ist.

## Revendications

1. Film adhésif thermodurcissable ayant une première et une seconde surfaces principales comprenant :
une matrice adhésive uniforme contenant une résine thermodurcissable, un agent destiné à durcir celle-ci et une résine thermoplastique ; et
un matériau de remplissage dispersé dans la matrice adhésive comprenant :
un matériau inorganique ; et
un domaine incorporant le matériau inorganique,
le domaine se composant d'un polymère élastique qui est de forme allongée et est orienté dans une direction d'orientation, essentiellement perpendiculaire à une direction d'épaisseur du film adhésif.

2. Film adhésif selon la revendication 1 qui est obtenu en enduisant dans une direction, avec une force de cisaillement, une composition de revêtement comprenant un composant de formation de matrice adhésive uniforme comprenant une résine thermodurcissable et un agent destiné à durcir celle-ci et une résine thermoplastique, où le composant de formation de matrice et la résine sont miscibles l'un à l'autre ; et comprenant en outre un matériau de remplissage inorganique dispersé dans le composant de formation de matrice adhésive.

3. Film adhésif selon la revendication 1 ou la revendication 2, dans lequel la résine thermodurcissable est une résine époxy et la résine thermoplastique est une résine phénoxy.

4. Film adhésif selon l'une quelconque des revendications 1 à 3, dans lequel le rapport de mélange entre la résine thermodurcissable et la résine thermoplastique est de 70/30 à 5/95 en poids.

5. Film adhésif selon l'une quelconque des revendications 1 à 4, dans lequel le matériau de remplissage inorganique est contenu dans le composant de formation de matrice adhésive en une quantité de 5 à 100 parties en masse par rapport à 100 parties en masse du composant de formation de matrice adhésive.

6. Film adhésif selon l'une quelconque des revendications 1 à 5, ayant un module élastique de 1 MPa à 1000 MPa dans une direction parallèle à la direction d'orientation du domaine, et un module élastique de 0,1 MPa à 10 MPa dans une direction normale à la direction d'orientation, mesuré à 150°C après durcissement.

7. Film adhésif selon l'une quelconque des revendications 1 à 6, qui a un coefficient de dilatation thermique linéaire de 1 à 200 x 10⁻⁶/°C dans une direction parallèle à la direction d'orientation du domaine, et un coefficient de dilatation thermique linéaire de 10 à 500 x 10⁻⁶/°C dans une direction normale à la direction d'orientation, mesuré à une température comprise entre -50 et 150°C après durcissement.

8. Film adhésif thermodurcissable obtenu en stratifiant une pluralité de films adhésifs selon l'une quelconque des revendications 1 à 7, en une stratification multicouche dans laquelle les couches adjacentes ont des domaines orientés à angles droits entre eux, et chacun des films adhésifs stratifiés est obtenu en enduisant une composition de revêtement ayant une viscosité de 1 à 1 000 Pa.s (1 000 à 1 000 000 cps) à un taux de cisaillement de 100 à 1 000 000 sec⁻¹.

9. Structure adhésive comprenant :
un produit durci obtenu à partir d'un film adhésif selon l'une quelconque des revendications 1 à 8 ;
un premier support à coller attaché à la première surface principale du produit durci du film adhésif ; et
un second support à coller attaché à la deuxième surface principale du produit durci du film adhésif.
